# FASCICULE DE BREVET EUROPEEN

(11) **EP 0 687 997 B1**
(45) Date de publication et mention de la délivrance du brevet: **13.07.2005**
(21) Numéro de dépôt: 95108585.1
(22) Date de dépôt: 06.06.1995
(51) Int. Cl.: G07C 3/10

(54) **Dispositif pour assurer la qualité de la production d'une presse de fabrication d'emballages**
Vorrichtung zum Sichern der Produktqualität einer Presse zur Herstellung von Verpackungen
Device for assuming the product quality of a packaging fabrication press

(30) Priorité: 17.06.1994 CH 191794
(43) Date de publication de la demande: 20.12.1995
(73) Titulaire: BOBST S.A., 1001 Lausanne (CH)
(72) Inventeur: Chiari, Mauro, CH-1007 Lausanne (CH)
(74) Mandataire: Colomb, Claude

(56) Documents cités:
- EP-A- 0 452 769
- US-A- 4 934 228
- PATENT ABSTRACTS OF JAPAN vol. 009, no. 242 (M-417), 28 septembre 1985 & JP 60 096461 A (TOPPAN INSATSU KK), 30 mai 1985,

## Description

La présente invention a pour objet un dispositif pour assurer la qualité de la production d'une presse de fabrication d'emballages imprimés, notamment pour assurer la qualité de la production d'une presse de fabrication d'emballages imprimés en carton ou en carton ondulé.

On connaît déjà plusieurs dispositifs permettant un contrôle automatique de la qualité de la production d'une presse de fabrication d'emballages, notamment de la qualité de l'impression et du découpage. L'un de ces dispositifs utilise une caméra placée de façon à ce que son champ optique balaie une zone du déchet frontal dans laquelle sont aménagées d'une part une encoche sensiblement rectangulaire et une série de marque de repérage des couleurs de l'image imprimée sur une feuille ayant été travaillée par la presse à découper. Un tel dispositif ainsi que son procédé de fonctionnement sont décrits dans le brevet EP 452'769.

Le brevet US 4,934,228 mentionne un dispositif de déroutage de feuilles de bois utilisées dans la fabrication de panneaux de contreplaqués. Le dispositif de l'invention comprend notamment une station de détection équipée d'une rangée transversale de scanners supérieurs situés en vis-à-vis d'une rangée de scanners inférieurs. Ces paires de scanners permettent de déterminer l'épaisseur de la feuille de bois issue de la production. Lorsqu'une variation trop importante de cette épaisseur est détectée, l'emplacement du défaut est mémorisé par un ordinateur, puis peut être marqué sur la feuille à l'aide d'une buse projetant un jet de peinture. La portion défectueuse est ensuite déroutée vers une voie d'évacuation. En fonction de l'emplacement du défaut repéré sur la portion de feuille déroutée, un opérateur peut ensuite aisément déterminer la meilleure façon dont il faut couper ladite portion pour en récupérer une part si nécessaire.

Un autre dispositif de surveillance de la qualité de la production d'une presse de fabrication d'emballages utilise également une caméra associée à un dispositif de traitement d'images pour détecter et mémoriser la position d'éléments de repérage disposés sur le déchet frontal d'une feuille dans laquelle sont découpés les emballages. Ce déchet frontal est ensuite séparé de la feuille avant de passer dans le champ optique de la caméra et pour terminer il est évacué, par exemple, sur un tapis roulant. Dans ce dispositif, le bord frontal d'une feuille, prise d'un paquet, est introduit dans une barre de pinces déplacée par un train de chaînes. La feuille est ensuite transportée au travers des diverses stations de travail de la presse. Après la station de réception de la presse, seul subsiste sur la barre à pinces le déchet frontal de la feuille. Le déchet frontal, ôté de la barre à pinces dans un endroit situé sur le retour par le haut du train de chaînes, sera évacué de la machine au moyen d'un tapis roulant. Il est rappelé que chacune de ces opérations est effectuée à un arrêt des barres à pinces.

A un arrêt de la barre à pinces situé après la station de réception de la presse, mais avant l'arrêt pour l'évacuation du déchet frontal, est prévue une caméra placée au-dessus et en face du déchet frontal. Le déchet présente une zone ayant une série de perforations. Ces perforations sont disposées suivant deux diagonales.

A proximité immédiate des perforations on aura imprimé, de façon connue, cinq marques de repérage de couleur, chaque marque correspondant à un des cinq groupes imprimeurs d'une machine d'impression par flexographie. Chaque marque correspond donc à une couleur. Un nombre supérieur ou inférieur à cinq marques peut bien sûr être envisagé, cela en fonction du nombre de groupes imprimeurs utilisés.

Pour que la caméra puisse lire les marques de repérage avec suffisamment de précision, de sûreté et de rapidité, les conditions suivantes doivent, de préférence, être remplies :
- les marques doivent être alignées sur l'axe longitudinal du déchet passant par le point central des perforations;
- les carrés et rectangles ne sont pas autorisés pour les marques;
- entre chaque marque un écart minimum est requis;
- chaque marque a une hauteur et une largeur de 3 à 6 mm;
- la disposition des cinq marques par rapport aux perforations doit être telle que les marques et les perforations se trouvent dans un unique champ de vision de la caméra.

La caméra a donc pour fonction de lire simultanément les cinq marques et les perforations lorsque le déchet est à l'arrêt; à chaque lecture, le déchet est éclairé au moyen d'un flash dont la commande est synchronisée avec celle de la machine de découpage. Le flash permet de diminuer au maximum les causes ambiantes d'erreur ou d'imprécision de lecture, telles que, par exemple, la vibration du déchet dans le sens du train de chaînes. Le flash peut être remplacé par un éclairage continu à temps d'exposition contrôlé.

Un tel dispositif est décrit dans le brevet CH 689'770.

L'un des principaux inconvénients de ce genre de dispositifs réside dans le fait que la détection d'une feuille défectueuse à lieu après que celle-ci a déjà été empilée dans la station de réception de la presse et que plusieurs feuilles sont déjà venues la recouvrir ce qui nécessite de trier la pile réceptionnée pour enlever la feuille défectueuse ce qui ne pourra se faire qu'en examinant attentivement chaque dernières feuilles de l'empilage. Une autre possibilité offerte par ce genre de dispositifs consiste à arrêter la presse dès qu'une feuille défectueuse a été détectée. Ces arrêts de la presse peuvent être fréquents et de ce fait être néfastes quant au rendement de celle-ci. De plus, la feuille défectueuse ne présentant pas de marque particulière, sa détection, dans la pile, parmi les autres feuilles sera difficile.

La présente invention a pour but d'éliminer les inconvénients précités. Ce but est atteint grâce à un dispositif selon la revendication 1.

En vue de faciliter la compréhension de l'invention, il sera maintenant décrit un mode de réalisation de l'invention en référence au dessin annexé dans lequel :
- La figure 1 montre une vue d'ensemble sous forme de schéma d'une presse de fabrication d'emballages complétée par un schéma bloc simplifié des organes de contrôle de qualité de l'impression et du découpage et de commande d'un dispositif de marquage,
- La figure 2 montre partiellement la partie frontale inférieure d'une feuille, provenant de la presse de fabrication d'emballages, dont le déchet frontal est muni de marques de repérage de couleurs et d'une marque de repérage de la position de la découpe constituée par un trou réalisé par un poinçon,
- La figure 3 montre partiellement, comme la figure 2, la partie frontale inférieure d'une feuille, provenant d'une presse de fabrication d'emballages, dont le déchet frontal est muni de marques de repérage de couleurs et d'une marque de repérage de la position de la découpe constituée par un trou réalisé par un poinçon, la feuille comportant une empreinte d'identification,
- La figure 4 représente, la disposition de la caméra de contrôle de qualité à la sortie de la station de découpage,
- La figure 5 est une vue du détail A de la figure 4 et,
- La figure 6 est une vue de détail montrant l'organe de marquage des feuilles défectueuses.

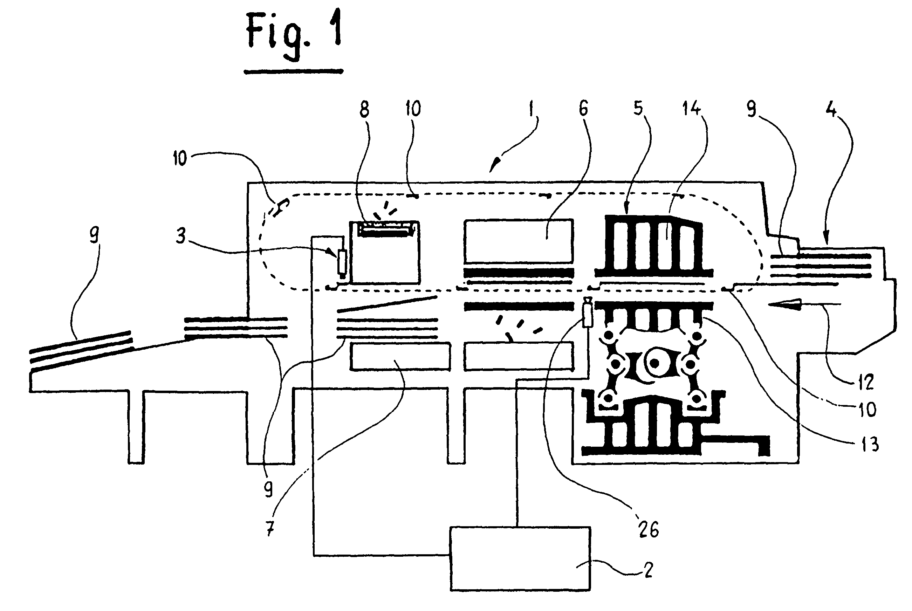

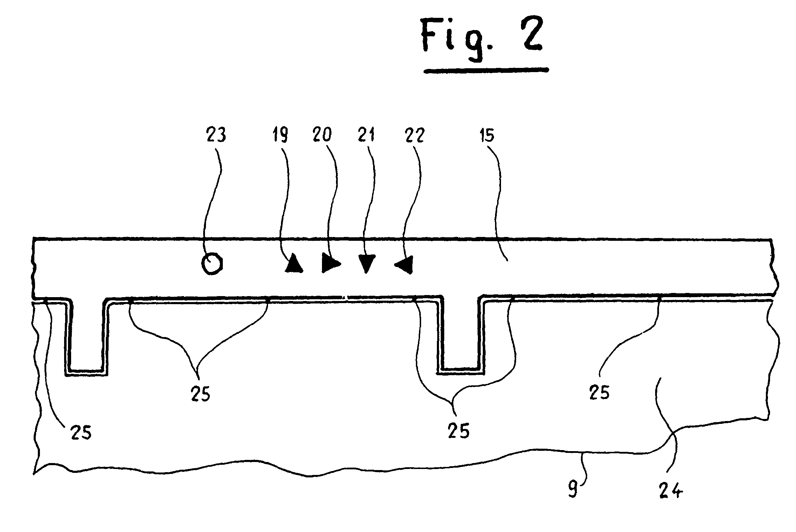

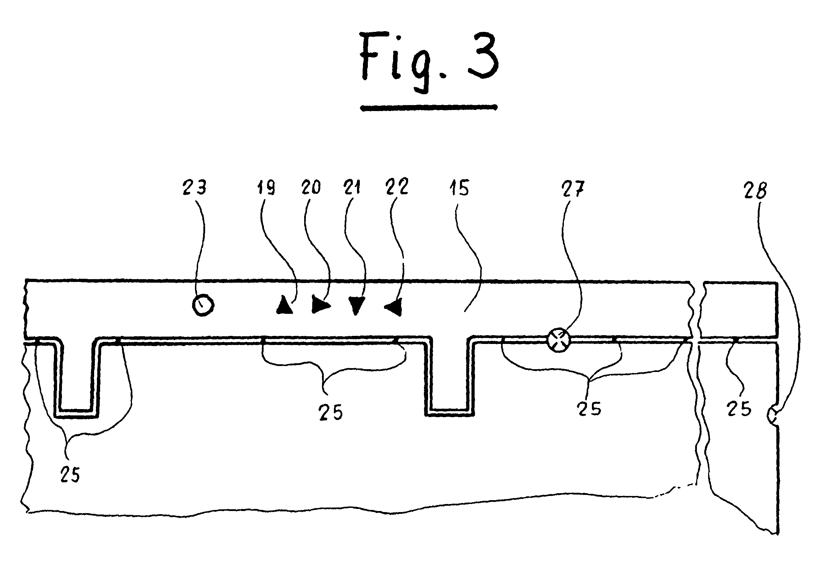

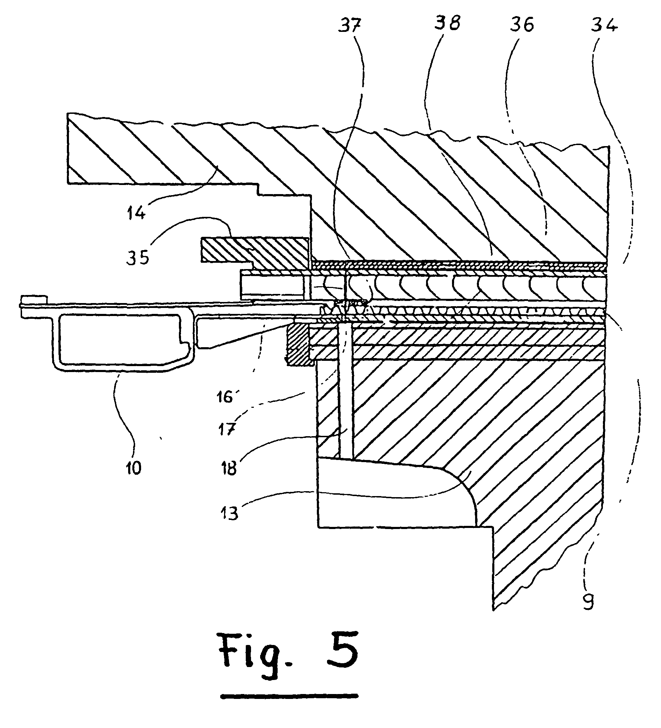

La figure 1 montre une vue d'ensemble sous forme de schéma d'une presse de fabrication d'emballages 1 complétée par un schéma bloc simplifié 2 des organes de contrôle de qualité de l'impression et du découpage et de commande d'un dispositif de marquage 3. La presse de fabrication d'emballages 1 comprend dans l'ordre une station d'alimentation 4, une station de découpage 5, une station d'éjection des déchets 6 et une station de réception 7 surmontée d'un tapis roulant 8 destiné à évacuer les déchets frontaux des feuilles 9 travaillées par la machine de découpage. Les feuilles 9 de carton à découper sont transportées au travers de la machine par des barres de pinces 10 entraînées par un train de chaînes 11, dans le sens indiqué par la flèche 12. Généralement, la station de découpage 5 comprend un sommier mobile inférieur 13 sur lequel est fixée la contre-forme de découpage et un sommier supérieur 14 fixe sur la face inférieure duquel est fixé l'outil de découpage. De façon à pouvoir repérer le déchet frontal 15 (voir figures 2 et 3) par rapport aux différentes découpes de boîtes pliantes découpées par l'outil de découpage, on prévoit de placer, sensiblement dans l'axe médian longitudinal de la machine, un poinçon 16 (voir figures 2 et 3) dans une zone correspondant à la position du déchet frontal 15. Ce poinçon 16 est de préférence fixé sur l'outil de découpage et travaille conjointement avec une matrice 17 agencée dans la contre forme de découpage (voir figure 5). Un alésage d'évacuation 18 des déchets de poinçonnage est prévu dans le sommier mobile inférieur 13. De ce fait, chaque fois qu'une opération de découpage aura lieu, le déchet frontal 15 sera marqué par le poinçon 16 et cela en parfait repérage entre l'outil de découpage et le déchet frontal 15. Dans l'exemple choisi ici, le poinçon 16 et la matrice 17 sont de forme circulaire. Les organes de contrôle de qualité de l'impression et du découpage 2 comprennent une caméra 26 placée à la sortie de la station de découpage 5 de telle façon à pouvoir lire les marques apposées sur la face inférieure des feuilles 9 lorsque celles-ci se déplacent. Une telle lecture est connue du document cité dans l'introduction de la présente description mais cette lecture a lieu à un emplacement différent de la presse de fabrication d'emballages 1 et lorsque le déchet frontal 15 est à l'arrêt. Les organes de contrôle de qualité de l'impression et du découpage 2, étant pratiquement les mêmes que ceux utilisés dans le brevet CH 689'770 ne seront pas décrits plus en détail, mais l'on précisera que soit le signal d'alarme ou soit le signal d'arrêt de la machine pourront être utilisés pour déclencher la mise en action de l'organe de marquage 3.

La figure 2 montre partiellement la partie frontale inférieure d'une feuille 9, provenant de la presse de fabrication d'emballages 1, dont le déchet frontal 15 est muni de marques de repérage de couleurs 19 à 22 et d'une marque de repérage de la position de la découpe constituée par un trou 23 réalisé par le poinçon 16. Sur cette figure, les différentes poses ou découpes 24 de la feuille 9 sont représentées d'une manière simplifiée et elles sont reliées au déchet frontal 15 par des points d'attache 25. Ces différentes marques apparaissent sur la face inférieure de la feuille 9 et seront lues par la caméra 26.

La figure 3 montre partiellement, comme la figure 2, la partie frontale inférieure d'une feuille 9, provenant d'une presse de fabrication d'emballages 1, dont le déchet frontal 15 est muni de marques de repérage de couleurs 19 à 22 et une marque de repérage de la position de la découpe constituée par un trou 23 réalisé par le poinçon 16, la feuille 9 comportant une empreinte d'identification 27. Ainsi que cela apparaît sur cette figure, l'empreinte d'identification 27 est réalisée par perforation d'au moins une zone de la feuille 9. Une première zone est située entre le déchet frontal 15 et les découpes 24 et une seconde zone est située sur l'un des bords de la feuille 9. L'empreinte d'identification de la seconde zone située sur l'un des bords de la feuille 9 aura la référence 28.

Cette façon d'identifier les feuilles 9 défectueuses permet de les repérer très facilement dans une pile car la marque d'identification apparaît très visiblement à l'observation du flanc de la pile correspondant à l'emplacement choisi pour le marquage.

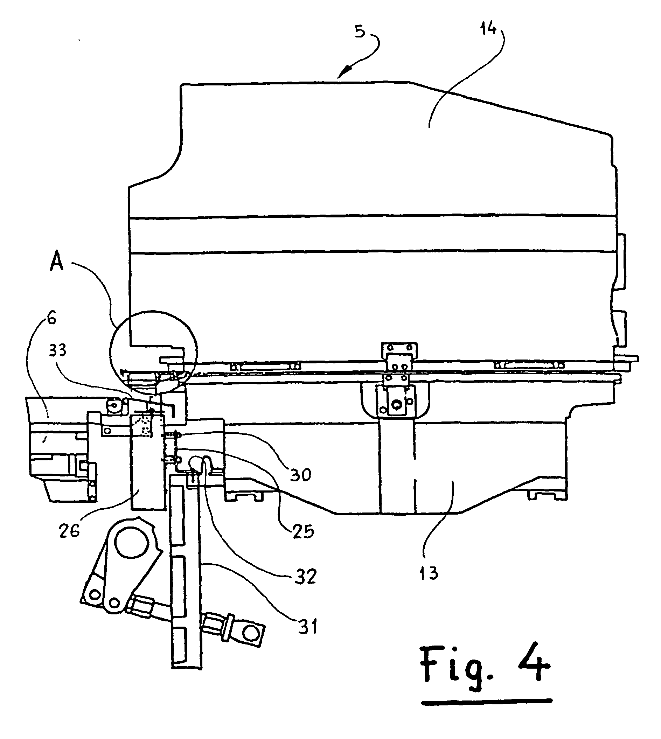

La figure 4 représente la disposition de la caméra de contrôle de qualité 26 à la sortie de la station de découpage 5. La caméra de contrôle de qualité 26 est fixée sur un support 29 par des vis 30. Ce support 29 peut être déplacé latéralement par rapport au sens de passage des feuilles dans la machine de découpage 1 de façon à régler sa position en fonction de l'emplacement des marques de repérage de l'impression et de la marque de repérage du découpage sur la feuille 9. Le support 29 est fixé sur la joue d'étanchéité 31 de la station de découpage 5 par des vis 32 s'engageant dans un écrou disposé dans une rainure en queue d'aronde (non représenté). Dans le but de ne pas laisser la poussière de carton s'accumuler sur l'objectif de la caméra 26 on a prévu au dessus de celui-ci une protection transparente 33 qui sera continuellement nettoyée par le déplacement d'air provoqué par le passage des feuilles 9 dans la presse de fabrication d'emballages 1.

La figure 5 est une vue du détail A de la figure 4 montrant la manière dont le poinçon 16 est fixé, par exemple dans un plot rapporté à l'aide de vis, dans l'outil de découpage 34 lui-même fixé par un organe de serrage 35 contre la face inférieure du sommier supérieur 14 fixe. Une plaque de protection 36 en acier recouvre la partie supérieure de l'outil de découpage. Pour améliorer le fonctionnement du poinçon 16, on l'associe à un appui 37 en caoutchouc mousse collé contre la face inférieure de l'outil de découpage 34. Ainsi, la feuille 9 sera bien maintenue lors de la perforation par le poinçon 16 s'engageant dans la matrice 17 agencée dans la contre forme 38.

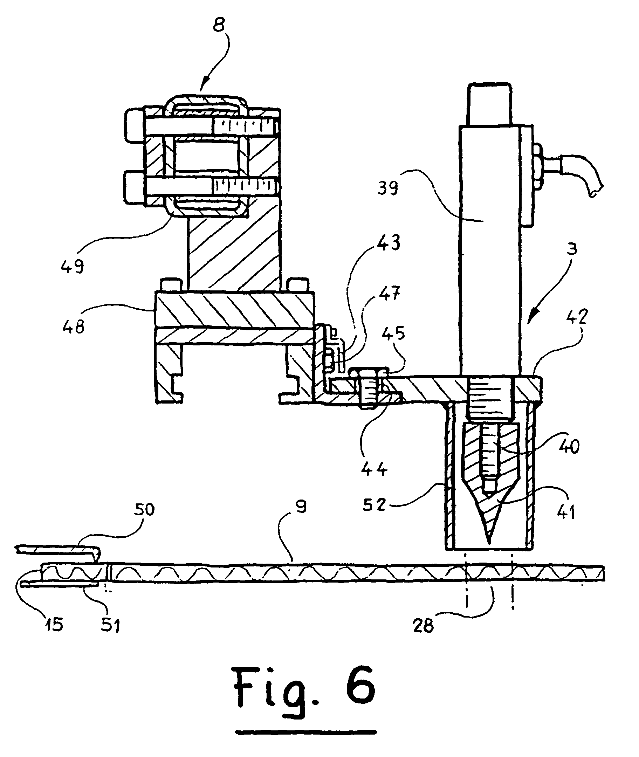

La figure 6 est une vue de détail montrant l'organe de marquage 3 des feuilles 9 défectueuses. L'organe de marquage 3 comprend un cylindre pneumatique 39 dont la tige de piston 40 est équipée d'un perforateur 41. Le perforateur 41 est protégé par une enceinte 52 soudée contre la face inférieure d'une plaquette fixation 42. De préférence, le perforateur 41 sera de forme conique. Le perforateur 41 pourra même présenter, dans sa partie conique, des lèvres coupantes qui assureront une meilleure empreinte d'identification 27 ou 28. Le piston pneumatique 39 est vissé dans la plaquette de fixation 42 qui est réglable en position latérale en fonction de largeur du format des feuilles 9 travaillées par la presse de fabrication d'emballages 1. Ce réglage peut s'effectuer au moyen de réglettes graduées gravées sur la plaquette de fixation 42 et d'un index 43. La plaquette de fixation 42 possède des trous allongés 44 traversés par des vis de blocage 45 de façon à pouvoir déplacer et bloquer l'organe de marquage 3 dans la position désirée. Les vis de blocage 45 maintiennent la plaquette de fixation 42 sur une cornière 46 vissée, à l'aide des vis 47 contre l'une des faces d'un support 48 solidaire du cadre supérieur 49 du dispositif de séparation (non représenté) du déchet frontal 15 qui, sur cette figure est encore pris dans les mâchoires 50 et 51 des pinces de la barre de pinces 10. Ainsi, l'organe de marquage 3 suivra les mouvements verticaux de la feuille 9 après qu'elle ait été séparée de son déchet frontal 15 et, dans le cas d'une feuille 9 défectueuse, le piston pneumatique sera actionné par les organes de contrôle de qualité et le perforateur 41 provoquera une marque d'identification 28 sur le bord correspondant de la feuille 9. Ainsi que cela a déjà été évoqué en rapport avec la figure 3, l'organe de marquage 3 pourrait aussi être placé de telle façon à ce que la marque d'identification soit faite à un autre endroit de la feuille 9, par exemple entre le déchet frontal 15 et les découpes 24.

On pourrait imaginer de remplacer l'organe de marquage 3 à perforateur 41 par une buse projetant, sur la tranche d'une feuille 9 défectueuse, un encre sensible aux rayons ultra-violets et de détecter la feuille 9 défectueuse à l'aide d'une source lumineuse. Une autre possibilité consisterait à utiliser un dispositif de marquage 3 qui collerait, sur l'un des bords latéraux d'une feuille 9 défectueuse, une bandelette qui permettrait facilement de repérer cette feuille 9 dans la pile formée après la station de réception 7 de la presse de fabrication d'emballages 1.

Les avantages apportés par un tel dispositif résident dans le fait qu'il n'est plus nécessaire d'arrêter la presse de fabrication d'emballages 1 lors de la détection d'une feuille 9 défectueuse, cette feuille 9 pouvant être aisément détectée et retirée de la pile formée après la station de réception 7 de la machine.

## Revendications

1. Dispositif pour assurer la qualité de la production d'une presse de fabrication d'emballages imprimés, notamment pour surveiller la qualité de la production d'une presse de fabrication d'emballages en carton ou en carton ondulé comprenant dans l'ordre, une station d'alimentation (4), une station de découpage (5), une station d'éjection des déchets (6) et une station de réception (7), la production de cette presse étant contrôlée par des organes de contrôle de qualité de l'impression et du découpage (2) comportant entre autres une caméra (26) pour la lecture de marques de repérage de l'impression (19 à 22) et d'une marque de repérage de la position du découpage (23), **caractérisé en ce que** la caméra (26) est placée à la sortie de la station de découpage (5) de façon à lire des marques (19 à 23) apposées sur la face inférieure d'une feuille (9), **en ce qu'**un dispositif de marquage (3), piloté par les organes de contrôle de qualité de l'impression et du découpage (2), est agencé dans la station de réception (7) de la presse de fabrication d'emballages (1) et **en ce que** la feuille (9) comporte une empreinte d'identification (27, 28) réalisée par marquage d'au moins une zone située entre le déchet frontal (15) et les découpes (24) ou située sur l'un des bords de ladite feuille (9).

2. Dispositif selon la revendication 1, **caractérisé en ce que** la caméra (26) est montée, à la sortie de la station de découpage (5), de façon à pouvoir être déplacée latéralement en fonction de la position des marques (19 à 23) apposées sur la face inférieure de la feuille (9).

3. Dispositif selon la revendication 1, **caractérisé en ce que** la marque de repérage de la position du découpage (23) est réalisée par un poinçon (16), fixé dans un outil de découpage (34) de la presse de fabrication d'emballages (1) et par une matrice (17) aménagée dans la contre forme (38) de l'outil de découpage (34).

4. Dispositif selon la revendication 1, **caractérisé en ce que** le dispositif de marquage (3) comprend un cylindre pneumatique (39) sur la tige (40) duquel est monté un perforateur (41), le cylindre pneumatique (39) étant solidaire d'une plaquette de fixation (42) réglable latéralement de façon à pouvoir ajuster la position du dispositif de marquage (3) en fonction du format de la feuille (9) à travailler et **en ce que** le dispositif de marquage (3) est agencé de manière à suivre les mouvements verticaux du cadre supérieur (49) d'un dispositif de séparation du déchet frontal (15) de la feuille (9).

5. Dispositif selon la revendication 1, **caractérisé en ce que** le dispositif de marquage (3) est constitué par une buse projetant, sur la tranche d'une feuille (9) défectueuse, une encre sensible aux rayons ultra-violets.

6. Dispositif selon la revendication 1, **caractérisé en ce que** le dispositif de marquage (3) est constitué par un organe déposant une bandelette sur l'un des bords latéraux d'une feuille (9) défectueuse.

## Patentansprüche

1. Vorrichtung zur Überwachung der Produktionsqualität einer Presse zur Herstellung von gedruckten Verpackungen, und insbesondere zur Überwachung der Produktionsqualität einer Presse zur Herstellung von Verpackungen aus Karton oder Wellpappe der Reihe nach umfassend eine Einführstation (4), eine Stanzstation (5), eine Abfallausbrechstation (6) und eine Auslagestation (7), wobei die Produktion dieser Presse von Vorrichtungen zur Überwachung der Druck- und Stanzqualität (2) überwacht wird, die unter anderem eine Kamera (26) zur Lesung von Druckpassermarken (19 bis 22) und einer Passermarke für die Stanzposition (23) umfassen, **dadurch gekennzeichnet, dass** die Kamera (26) am Ausgang der Stanzstation (5) so angeordnet ist, dass sie die auf der Unterseite eines Bogens (9) angebrachten Marken (19 bis 23) liest, dass eine Markierungsvorrichtung (3), die durch die Vorrichtungen zur Überwachung der Druck- und Stanzqualität (2) gesteuert wird, in der Auslagestation (7) der Verpackungsherstellungspresse (1) angeordnet ist, und dass der Bogen (9) einen Identifikationsabdruck (27, 28) enthält, der durch Markierung von mindestens einem Bereich, der sich zwischen dem Vorderrandabfall (15) und den Zuschnitten (24) oder auf einem Rand des besagten Bogens (9) befindet, erzielt wird.

2. Vorrichtung gemäss Patentanspruch 1, **dadurch gekennzeichnet, dass** die Kamera (26) am Ausgang der Stanzstation (5) so angebracht ist, dass sie seitlich in bezug auf die Position der auf der Unterseite des Bogens (9) angebrachten Marken (19 bis 23) bewegt werden kann.

3. Vorrichtung gemäss Patentanspruch 1, **dadurch gekennzeichnet, dass** die Passermarke der Stanzposition (23) durch einen Stanzstift (16), der im Stanzwerkzeug (34) der Verpackungsherstellungspresse (1) befestigt ist, und durch eine Matrize (17), die in der Gegenform (38) des Stanzwerkzeugs (34) angeordnet ist, erzielt wird.

4. Vorrichtung gemäss Patentanspruch 1, **dadurch gekennzeichnet, dass** die Markierungsvorrichtung (3) einen Pneumatikzylinder (39) umfasst, auf dessen Stange (40) eine Perforiervorrichtung (41) angebracht ist, wobei der Pneumatikzylinder (49) mit einer Befestigungsplatte (42) fest verbunden ist, die seitlich einstellbar ist, so dass die Position der Markierungsvorrichtung (3) in bezug auf das Format des zu bearbeitenden Bogens (9) eingestellt werden kann, und dass die Markierungsvorrichtung (3) so angeordnet ist, dass sie den vertikalen Bewegungen des oberen Rahmens (49) einer Trennvorrichtung des Vorderrandabfalls (15) vom Bogen (9) folgt

5. Vorrichtung gemäss Patentanspruch 1, **dadurch gekennzeichnet, dass** die Markierungsvorrichtung (3) aus einer Düse besteht, die eine auf ultraviolette Strahlen empfindliche Tinte auf einen Abschnitt eines defekten Bogens (9) sprüht.

6. Vorrichtung gemäss Patentanspruch 1, **dadurch gekennzeichnet, dass** die Markierungsvorrichtung (3) aus einer Vorrichtung besteht, welche einen Streifen auf einen Seitenrand eines defekten Bogens (9) deponiert.

## Claims

1. Device for maintaining the production quality of a printed packaging manufacturing press and more particularly for monitoring the production quality of a press that manufactures cardboard or corrugated cardboard packaging comprising in succession an infeed station (4), a diecutting station (5), a waste stripping station (6) and a delivery station (7), the production of this press being monitored by means for monitoring the printing and diecutting quality (2) comprising among others a camera (26) for reading printing register marks (19 to 22) and a register mark for the diecutting position (23), **characterized in that** the camera (26) is placed at the outlet of the diecutting station (5) so as to read the marks (19 to 23) made on the lower surface of a sheet (9), **in that** a marking device (3), actuated by the means for monitoring the printing and diecutting quality (2), is disposed in the delivery station (7) of the packaging manufacturing press (1) and **in that** the sheet (9) compnses an identification imprint (27, 28) made by marking of at least one area located between the front waste (15) and the blanks (24) or located on one edge of the said sheet (9).

2. Device according to claim 1, **characterized in that** the camera (26) is disposed, at the outlet of the diecutting station (5), so that it can be moved laterally in dependence of the position of the marks (19 to 23) made on the lower surface of the sheet (9).

3. Device according to claim 1, **characterized in that** the register mark for the diecutting position (23) is made by a punch (16), secured in the diecutting tool (34) of the packaging manufacturing press (1) and by a matrix (17) formed in the counter-tool (38) of the diecutting tool (34).

4. Device according to claim 1, **characterized in that** the marking device (3) comprises a pneumatic cylinder (39) on the rod (40) of which is mounted a perforator (41), the pneumatic cylinder (39) being secured to a fastening plate (42) laterally adjustable so as to adjust the position of the marking device (3) in dependence on the size of the sheet (9) to be processed and **in that** the marking device (3) is arranged so as to follow the vertical movements of the upper frame (49) of a device for separating the front waste (15) from the sheet (9).

5. Device according to claim 1, **characterized in that** the marking device (3) is a nozzle which sprays an ink sensitive to ultra-violet rays on to the edge of a defective sheet (9).

6. Device according to claim 1, **characterized in that** the marking device (3) is a means which deposits a strip on one lateral edge of a defective sheet (9).
